# EUROPEAN PATENT APPLICATION

(11) **EP 0 735 478 A1**
(43) Date of publication of application: **02.10.1996**
(21) Application number: 95830126.9
(22) Date of filing: 31.03.1995
(51) Int. Cl.: G06F 11/267, G01R 31/3185

(54) **Variable configuration data processing system with automatic serial test interface connection configuration and bypass device**

(71) Applicant: BULL HN INFORMATION SYSTEMS ITALIA S.p.A., 10014 Caluso (Torino) (IT)
(72) Inventor: Gaio, Roberto, I-20020 Villa Cortese, Milano (IT); Grassi, Maurizio, I-20010 Pregnana Milanese, Milano (IT)
(74) Representative: Falcetti, Carlo

(57) **Abstract**

A variable configuration data processing system having a serial test interface of known JTAG type, comprising an automatic serial test interface connection configuration and bypass device (22,23) which recognises the absence of an electronic unit in the connection sockets on a board and responds by activating a replacement route (24,25,26,27) for closure of the serial interface chain, and upon reception of a bypass mode control signal (DTS) excludes a plurality of electronic units from the chain by activating a bypass route (32,33).

## Description

The present invention relates to a device for bypass and automatic connection configuration of a serial test interface of type known as JTAG and defined by the specific IEEE standard 1149.1, and the associated variable configuration data processing system which uses this device.

It is known that in modern data processing systems, in order to allow an easier check on the functionality of the various electronic units or components, and also in the case of identification of the configuration of the system, use is made of a very simple serial test interface, separated from the , generally parallel, working interface used by the electronic units for intercommunication and to perform the system's required functions.

The JTAG test interface comprises five signals and associated support wires:
1. JTAGCLK periodic clock signal.
2. JTAGTMS test mode selection signal.
3. COLDRST initialising reset signal.
4. JTAGTDI serial data signal input to electronic unit.
5. JTAGTDO serial data signal output from an electronic unit.

When the test mode selection signal is asserted an electronic unit sets in an internal register, with the leading edge of the clock signal, the data signal present at the input, and with the trailing edge of the clock signal presents a data signal at its output.

With a succession of clock signal pulses it is therefore possible to send a string of binary data having control functions and test configurations to an electronic unit, and to receive from the unit a string of binary data in response.

It is particularly important that by suitably organising the test and interrogation procedures it is possible to link or cascade several units: the data output of one unit is connected to the data input of another unit.

The chain is closed by a control device which emits serially to the input a sequence of binary stimulation signals and receives from the last unit of the chain the response to the stimuli produced by the different units and transferred from them.

The system is particularly simple but the test operations are laborious and require a long execution time which is greater the greater the number of units connected in series by the interface.

Moreover the system is rigid because the transmission chain of the units cannot be interrupted, and this feature conflicts with the requirement, particularly felt in modern data processing systems, of modifying the system configuration in a simple manner with the addition of new units.

At the levels of integration offered by modern technology this operation is often reduced to the insertion of integrated components into sockets provided on a printed circuit board (or to the insertion of electronic "daughter" boards into connector sockets of an electronic "mother" boards) which operations can be performed, with some caution, even by an inexpert user because, in general it does not require soldering operations, although these are not excluded.

To allow a certain flexibility in the configuration it is necessary to provide connection systems having jumpers or manual switches, which from time to time must open or close connections in such a way as to allow insertion or removal of components in the test loop and ensure its continuity.

The provision of jumpers or manual switches involves not insignificant constructional complications and costs, as well as additional bulk and above all can be the source of connection errors which prejudice the entire functionality of the system.

Moreover it is not compatible with the automatic exclusion from operation of individual components which manifest defects, which is today allowed and offered by many components which can be logically excluded from a system upon command of the system itself whilst remaining physically present.

These limitations are obviated by the variable configuration data processing system with an automatic serial interface connection configuration and by-pass device which is the subject of the present invention, which allows:
- a predetermined number of electronic units to be excluded from the serial interface chain upon command,
- the serial interface chain to be adapted to the effective configuration of the system without the necessity for manual operations to set jumpers or switches, even in real time, and
- to verify the functionality of the device.

These results are achieved by an automatic interface configuration and by-pass device comprising an input and a serial data test output of a JTAG type interface, an ordered plurality of connection sockets, each for the connection to the system of an associated electronic unit, each of the sockets having a serial test data input terminal (to transfer serial test data to the associated unit), a serial test data output terminal (to receive serial test data from the associated unit) and an output signal terminal for indicating the absence of an associated electronic unit in the socket.

First connection means connect the serial test data output terminal of each socket, except the last, to the serial test data input terminal of the following socket in order.

Second connection means connect the serial test data input terminal of the first socket to the input of the device and third connection means connect the output serial test data terminal of the last socket to the serial data output of the device.

A plurality of logic switches, preferably but not necessarily three-state drivers, each associated with one of the sockets, is controlled by a signal indicating the absence of an electronic unit in the associated socket, to connect the serial test data input terminal of the associated socket, except the last, to the serial test data input terminal of the next socket in order, and the serial data input terminal of the last socket to the output of the device.

Finally, fourth connection means are provided, controlled by a signal, indicating test and bypass mode, generated by a serial interface test control unit, to connect the input of the device to its output.

The third connection means mentioned above, include control means, controlled by the bypass mode signal, to open the connection between the serial data output terminal of the last socket and the output of the device if the bypass mode signal is asserted.

The device can easily be made by integrating all the active components in an integrated circuit but preferably, for reasons of economy of scale and more immediate availability, is formed using integrated circuits available on the market, in particular a PAL (programmable logic network loop), a plurality of integrated logic switches and a plurality of integrated logic gates.

The characteristics and advantages of the invention will become more clearly apparent from the following description and from the attached drawings in which:
Figure 1 is a block diagram of the combination of a variable configuration data processing system and an automatic serial test interface connection configuration and by-pass device formed in accordance with the present invention;
Figure 2 is an electric-logic diagram of a first embodiment of the device of Figure 1;
Figure 3 is an electric-logic diagram of a second embodiment of the device of Figure 1; and
Figure 4 is an electric-logic diagram of a preferred embodiment of the device of Figure 1.

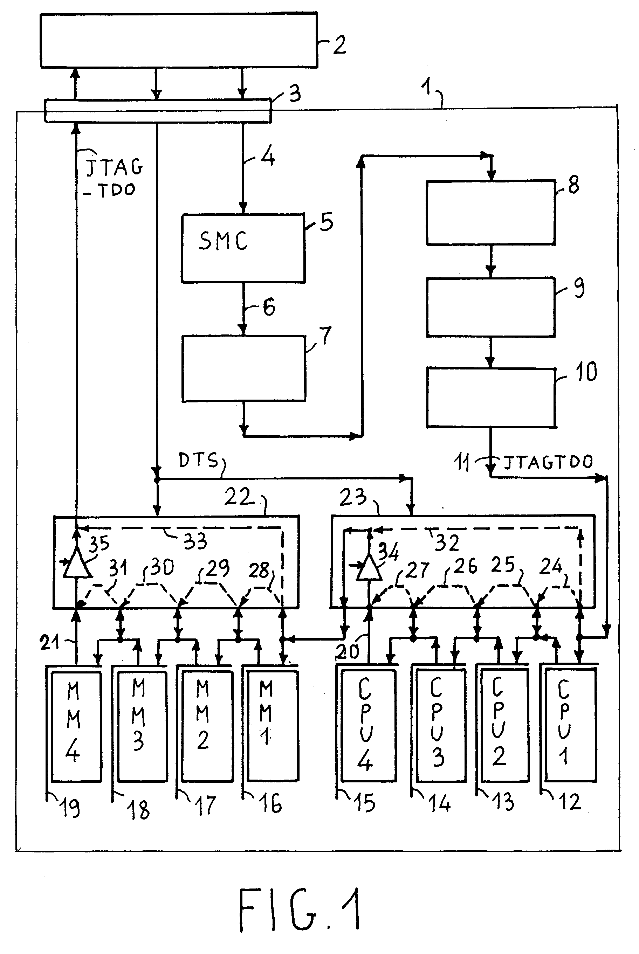

With reference to Figure 1, a data processing system which incorporates, according to the present invention, a bypass and automatic interface connection configuration device is constituted by printed circuit mother board 1 interconnected by means of connectors to other electronic units on other printed circuit boards. For example the board 2 represents an electronic supervision and test unit for testing the system via a JTAG serial interface of the type already mentioned.

Via the connector 3 the unit 2 sends a sequence of JTAGTDI binary data, on the wire 4, to the first 5 of a number of electronic units mounted on the board 1.

This is, for example, an integrated component which performs the function of system memory controller (SMC).

Clearly, although for simplicity these aspects are not shown, the unit 5 and all the other units connected in cascade via the JTAG interface receive the periodic clock signal, JTAGCLK and the test mode selection signal JTAGTMS.

In response to the signals received the unit 5 produces and sends, via a wire 6, to a second electronic unit 7, a sequence of binary data generally, but not necessarily, different from the first, and so on from electronic unit to electronic unit 8, 9, 10.

The units 7, 8, 9, 10 can be logic units for storing and distributing data between several memory modules and several central processing units.

The board 1 is configurable in dependence on the user's requirements, and can contain, in the example, from one to four central processing units CPU1, CPU2, CPU3, CPU4 in the form of integrated components which may be installed, preferably without soldering operations, in corresponding sockets 12, 13, 14, 15 of the board.

The JTAGTDO serial test data output wire 11 is connected to the serial test data input terminal of the JTAG interface of socket 12 for receiving CPU1.

The serial test data output terminal of the JTAG interface of socket 12 is connected to the serial test data input terminal of the JTAG interface of socket 13 for receiving CPU2 and so on in cascaded order as far as socket 15.

The serial test data output 20 of the JTAG interface of the last connection socket 15, in a conventional system, would be connected to the serial test data input of the JTAG interface of a subsequent electronic unit in order.

For example the board 1 contains a working memory and this too is configurable in dependence on the user's requirements and is constituted by a variable number, between 1 and 4, of memory modules MM1, MM2, MM3, MM4 engaged in connectors 16, 17, 18, 19 of the board 1.

Therefore in a conventional system the output 20 would be connected to the serial test data input of the connector 16 which supports the memory module MM1.

Connection between the serial data output terminal of a connector 16, 17, 18 with the input terminal of a successively ordered connector 17, 18, 19 forms the JTAG interface linking between the various memory modules.

Finally, the serial test data output terminal 21 of the last connector of the chain would be connected, in a conventional system, to a further electronic unit of the board 1 or, if there are no other units, to the JTAG TDO connection wire, via the connector 3, to the test and control unit 2.

This configurable architecture involves problems at two levels.

To ensure continuity of the JTAG interface chain even in the absence of any electronic units it is necessary to provide removable connection jumpers between the serial test data input and output terminals of the sockets 12, 13, 14, 15 and the connectors, 16, 17, 18, 19.

As already indicated this involves significant risks of error and failure and does not allow reconfiguration in real time of the system to put defective components out of service.

Moreover, if all or almost all of the electronic units are installed, the diagnostic serial interface chain is very long and the execution times of diagnostics procedures via the serial interface are also very long.

According to the invention, in order to obviate these disadvantages there are provided, in the architecture of Figure 1, two automatic serial test interface connection configuration and by-pass devices 22, 23.

These devices, as will be explained in more detail hereinbelow, comprise a plurality of logic gates, preferably three-state drivers which, in dependence on the absence of components in the chain, activate a bypass route via the serial test data input and output terminals of the sockets or connectors where the component is absent or, as appropriate, disactivated. More properly, for a greater descriptive generality, the bypass connection occurs between the input terminal of one socket and the input terminal of the following socket in order.

In Figure 1 the selectively activatable bypass routes are represented by the broken lines 24, 25, 26, 27, 28, 29, 30, 31.

The arrows associated with these lines indicate the direction of signal transfer.

Moreover, in order to speed up the diagnostic operations it is envisaged that the devices 22, 23, independently of the presence or otherwise of electric components in the respective sockets/connectors, will be able to activate, under the control of a DTS control signal generated for this specific purpose by the control unit 2, a bypass route 32, 33 respectively for the entire group of CPUs (CPU1, CPU2, CPU3, CPU4), and memory modules (MM1, MM2, MM3, MM4).

In this way it becomes possible to use the serial test interface to test only some of the components of the chain with the exclusion of others, thereby simplifying the test operations and their duration, and to introduce into the chain the other components, to perform complete and necessarily longer and more laborious test operations only when this is needed, or with a very much lower periodic frequency.

In activating this bypass route it is necessary to take into account that on the serial data output terminal of the interface of the last bypassed unit there are present signals inconsistent with those present on the bypass route.

For this reason the bypass route cannot be closed on to the output terminal of the last bypassed unit but on to a terminal of a separate bypass device, and connected to the output of the last bypassed unit via a controlling logic gate which opens the connection when the bypass route is activated.

In the devices 22, 23 of Figure 1 this controlling logic gate is represented by the three-state drivers 34, 35.

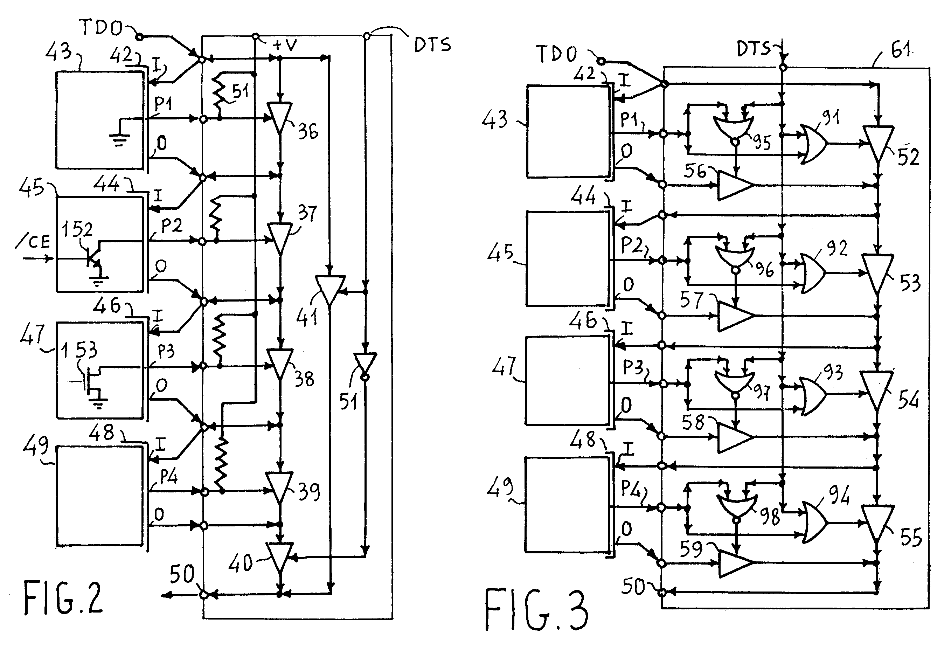

Figure 2 shows the electric logic diagram of an embodiment of the bypass device which is preferred for its constructional simplicity and because it can be made as an integrated circuit.

The device, provided for the automatic configuration of the connections of N=4 electronic components, only some of which may be present or active, essentially comprises N + 2 three-state drivers from 36 to 41, of which N + 1 are connected in series and the last, 41, is connected in parallel thereto.

The input of the first driver 36 of the series, and that of the driver 41, is connected to a serial data input terminal I of a socket 42 of a first electronic unit 43 and to the TDO output terminal of a preceding electronic unit in the JTAG chain.

This terminal TDO constitutes an input of the bypass device.

The output of the driver 36 is connected to a serial data output terminal O of the same socket 42 and to the serial data input terminal I of the socket 44 of an immediately succeeding electronic unit 45 in the serial interface chain.

Similarly, the output of the driver 37 is connected to the serial data output terminal O of the socket 44 and to the serial data input terminal I of the socket 46 of an immediately successive electronic unit 47, the output of the driver 38 is connected to the serial data output terminal O of the socket 46 and to the serial data input I of a socket 48 of a successively ordered electronic unit 49.

The output of the driver 39 is connected to the serial data output terminal O of the socket 48.

Finally, the outputs of the drivers 40 and 41 are connected to a serial data output terminal 50 of the whole logic chain provided by the device, and the electronic units connected to it.

The drivers 36, 37, 38 and 39 are enabled to close by an electric control signal at level 1 applied to a control input.

For each of the drivers this signal is generated by, or by the effect of, the presence of an electronic unit in the associated socket.

In Figure 2 are shown different examples of control signal generation circuits.

For example the control input of the driver 36 is biased at electric level 1 by a resistor and is connected to a control terminal P1 of the socket 42.

This terminal is simply connected to ground by the unit 43 when present. Thus if the unit 43 is present the driver 36 is open. If the unit 43 is absent the driver 36 is closed and active.

To allow detection not only of the presence of a unit, but also its active or inactive state, which is equivalent to the absence of the device, it is possible to control the earthing of the control terminal in dependence on the state of the unit.

For example, in the unit 45 of Figure 2 the control terminal P2 is connected to earth via a transistor 152 which obviously can be rendered conductive by a unit disabling signal /CE.

As shown in the unit 47, a MOS gate 153 can be used in place of the transistor 152. The nature of the control circuit depends essentially on the technology used in the electronic unit.

In summary, for each electronic unit detected as absent (because it is not present or because it is inactive) the corresponding driver 36, 37, 38, 39 provides a bypass connection between input and output which ensures the continuity of the transmission chain.

When the driver 41 is controlled to close by a DTS signal at level 1 generated by the unit 2 (Figure 1) and indicating, when asserted at level 1, of an operative bypass mode makes it possible to bypass the whole of the chain of units 43, 45, 47, 49 and to connect the TDO input terminal directly to the output terminal 50 of the device.

To avoid interference between the output signal from the driver 41 and the output signal from the unit 49 or, as appropriate, from the driver 39, the output of the driver 39 is connected to the terminal 50 via the driver 40 controlled to close by the DTS signal, inverted by an inverter 51.

A further advantage offered by the device of Figure 2 is that its functionality can be verified.

The functionality of the driver 41 when closed, and simultaneously the functionality when open of the driver 40, can be verified in the operative bypass and test mode (DTS asserted) because only in this case is there presentation on the terminal 50 of the same sequence of binary data received from the input terminal.

Otherwise, either there is no transfer of signals (drivers 41, 40 open) or there is transfer of signals processed by the chain of units present (driver 40 closed and 41 open) or in the case of drivers 40, 41 simultaneously closed, interference between the output signals and therefore alteration of the sequence of transferred data.

In this case, in fact, the two drivers with common output behave as a "connected AND", the electric level 0 prevailing over the electric level 1.

For similar reasons, during normal operation (DTS not asserted) it is possible to verify the correct closing and opening operation of the drivers 36, 37, 38, 39.

If, however, any one of the drivers 36, 37, 38, 39 is improperly closed, this can lead to an excessive absorption of current by the electronic unit the serial data output terminal of which is connected to the output of the active driver, and to the failure of the electronic unit if this is not envisaged for this working condition.

To avoid this disadvantage it is possible to form the bypass device as shown in the diagram of Figure 3, in which drivers 52, 53, 54, 55, which are connected in series, each with its input connected to the input I respectively of the socket 42, 44, 46, 48 of an electronic unit 43, 45, 47, 49 and its output connected to the terminal O of the success socket in order, or to the output terminal 50 of the device in the case of the driver 55, perform both the function of bypassing the ordered succession of electronic units 43, 45, 47, 49 and the function of bypassing the individual electronic unit identified as absent.

In this case the three-state drivers 52, 53, 54, 55 are enabled to close by the OR of the associated unit absent signal and the DTS signal applied to the inputs of the OR gates 91, 92, 93, 94 the output of which is connected to the control input of the drivers 52, 53, 54, 55 respectively.

The output terminals O of the various sockets are each connected to the output of the associated driver 52, 53, 54, 55 via a respective three-state driver 56, 57, 58, 59.

The three-state drivers 56, 57, 58, 59 each control the connection of the serial data output terminal of one electronic unit 43, 45, 47, 49 to the output of the corresponding bypass driver 52, 53, 54, 55.

The drivers 56, 57, 58, 59 are each controlled to close via a logic NOR gate 95, 96, 97, 98 respectively, by the respective electric level 0 "unit present" signal P1, P2, P3, P4 and DTS signal deasserted.

This has the dual purpose of avoiding interference between signals wired in AND, at the output of the two drivers connected together, and uncertainty in the output level of a driver when its input does not receive an electric signal at a defined level due to the absence of the electronic unit.

In this case, too, the device can be made as an integrated circuit 61.

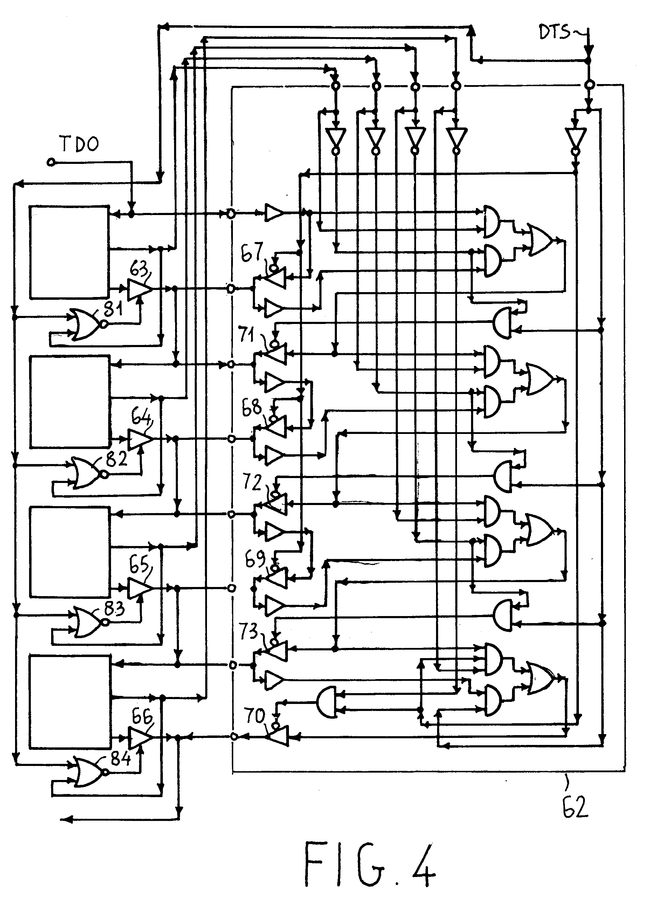

Figure 4 shows the logic diagram of a bypass device which adds to the values of the device of Figure 3 the further advantage of being made with a smaller number of commercially available integrated circuits, in particular a PAL or programmable array logic 62, an integrated circuit comprising a set of four three-state drivers 63, 64, 65, 66 and an integrated circuit comprising a set of four logic NOR gates 81, 82, 83, 84.

The three-state drivers 63, 64, 65, 66 perform the same function as is performed in Figure 3 by the drivers 56, 57, 58, 59.

In the PAL 62 the three-state drivers 67, 68, 69, 70 perform the function of bypass driver for the entire chain of electronic units with the serial data input and output terminals connected to the device, and the three-state drivers 71, 72, 73 and 70 perform the ordered bypass function to bypass individual electronic units identified as absent from the chain.

It is easy to recognise from an examination of the diagram that in the two different operative modes, normal and test, the device forms redundant communication routes which allow its functionality to be more easily verified.

The preceding description relates only to some preferred embodiments of the invention and many variants can be introduced.

For example, the various drivers, or parts of these, in Figures 2 and 3 can be of the type with inverting control input, that is to say controlled to close by a signal at electric level 0.

This requires the use of inverted control signals with respect to those considered, which signals can be easily obtained using NOT logic elements, with "pull down" or earth biased rather than "pull up" resistors and similar arrangements.

Moreover, the function of the device can be limited to that of automatic connection configuration.

In this case, in the diagram of Figure 2 the drivers 41, 40 and the inverter 51 are superfluous and can be omitted.

Similarly, in Figure 3 the OR gates can be omitted and the NOR gates replaced by simple inverters.

It is also clear that the number of electronic units which can be bypassed by each device can be different from four, for example greater or less, and determined only by the specific requirements of the system.

As illustrated in Figure 1, more bypass devices can be used in cascade, controlled by the same bypass mode signal or, if preferable, selectively controlled independently of the others by separate bypass mode signals.

It is also to be noted that no clock signal is required for the operation of the bypass device in its different embodiments described above.

## Claims

1. A variable configuration data processing system with an automatic serial test interface connection configuration and bypass device, in which the said bypass device comprises:
- a serial test data input (TDO) and a serial test data output (50),
- an ordered plurality of connection sockets (12, 13, 14, 15, 42, 44, 46, 48), each for the connection to the said system of an electronic unit (43, 45, 47, 49), the said ordered plurality comprising a first (12, 42) and last (15, 48) socket, each of the said sockets having a serial test data input terminal (I), a serial test data output terminal (O) and a terminal (P1, P2, P3, P4) for a signal indicating the absence of electronic unit in the said socket,
- first connection means (56, 57, 58, 63, 64, 65,) for connection of the said serial data output terminal of each socket, with the exception of the last, to the serial data input terminal of the successively ordered socket,
- second connection means for connecting the said serial test data input to the serial data input terminal of the said first socket,
- third connection means (40, 59, 66) for connecting the said serial test data output terminal of the said last socket to the said serial test data output (50),
- a first ordered plurality of logic switches (36, 37, 38, 39; 52, 53, 54, 55, 71, 72, 73, 70), each associated with one of the said sockets and controlled by the said electronic unit absence signal (P1, P2, P3, P4) received from the said associated socket to connect the said serial test data input terminal of the associated socket, except the last, to the serial test data input terminal of the successively ordered socket and the said serial data input terminal of the said last socket to the said serial test data output (50).

2. A data processing system as in Claim 1, in which the said device includes fourth connection means (51, 52, 53, 54, 55, 67, 68, 69, 70) controlled by a test mode indicator signal generated by a control unit (2) to connect the said serial test data input (TDO) to the said serial test data output (50), and in which the said third connection means comprise control means (40, 59, 70) controlled by the said test mode signal to open the said third connection means .

3. A system as in Claim 2, in which the said first connection means include a second plurality of logic switches (56, 57, 58, 59; 63, 64, 65, 66), each associated with one of the said serial test data output terminals, controlled to open by the OR logic of the said test mode signal (TDO) and by the electronic unit absence signal (P1, P2, P3, P4) output from the signal terminal of the associated socket, and in which the said third connection means include a logic switch controlled to open by the OR logic of the said test mode signal and by the electronic unit absence signal output from the signal terminal of the said last socket.

4. A system as in Claim 3, in which the said first ordered plurality of logic switches, and the said fourth connection means are formed by a programmable logic network (62) and the said second plurality of logic switches and the said logic switch of the said third connection means is formed in an integrated circuit.
